# FASCICULE DE BREVET EUROPEEN

(11) **EP 0 728 369 B1**
(45) Date de publication et mention de la délivrance du brevet: **22.07.1998**
(21) Numéro de dépôt: 95901480.4
(22) Date de dépôt: 10.11.1994
(51) Int. Cl.: H01L 39/24, H01L 39/12

(54) **MATERIAU MULTICOUCHES ET DISPOSITIF COMPRENANT CE MATERIAU**
MEHRSCHICHTENMATERIAL UND EINE DIESES MATERIAL ENTHALTENDE ANORDNUNG
MULTILAYER MATERIAL AND DEVICE COMPRISING SAME

(30) Priorité: 12.11.1993 FR 9313510
(43) Date de publication de la demande: 28.08.1996
(73) Titulaire: Lewiner, Jacques, 92210 Saint-Cloud (FR); UFINNOVA, 75009 Paris (FR); Lagues, Michel, 92260 Fontenay-aux-Roses (FR)
(72) Inventeur: LAGUES, Michel, F-92260 Fontenay-aux-Roses (FR)
(74) Mandataire: Burbaud, Eric
(86) Numéro de dépôt international: FR9401320
(87) Numéro de publication internationale: WO9513628

(56) Documents cités:
- EP-A- 0 451 641
- EP-A- 0 504 804
- JAPANESE JOURNAL OF APPLIED PHYSICS, PART 2 (LETTERS), 1 MAY 1991, JAPAN, VOL. 30, NR. 5A, PAGE(S) L830 - L833, ISSN 0021-4922, TSUKAMOTO A ET AL 'Low-temperature annealing effect on Bi-Sr-Ca-Cu-O thin films prepared by layer-by-layer deposition'
- J.Appl.Phys., Vol.70, No.8, 15 October 1991, pages 4371 à 4377; Y.Nakayama et al.: "Superconductivity of Bi2Sr2Can-1CunOy (n=2,3,4 and 5) thin films prepared in situ by molecular-beam epitaxy technique"

## Description

La présente invention concerne un matériau supraconducteur sous forme de film constitué de couches monomoléculaires qui sont superposées les unes aux autres sur un substrat, comportant au moins un premier ensemble de couches qui constitue un réservoir de charges électriques, et au moins un deuxième ensemble de couches qui forme une cellule supraconductrice et qui est constitué par un certain nombre n de couches supraconductrices séparées les unes des autres par des couches intercalaires, le réservoir de charges et la cellule supraconductrice étant contigus dans l'empilage de couches.

Tel qu'employé ici, le terme "couche monomoléculaire" signifie une couche constituée par une épaisseur unique des atomes ou molécules constituant ladite couche.

Un matériau tel que défini ci-dessus est divulgué par exemple dans le document EP-A-0 305 292. Toutefois, compte tenu du procédé d'obtention du matériau divulgué dans ce document, il est probable que ses couches ne soient pas strictement monomoléculaires et présentent de nombreux agrégats où les espèces constituant les couches sont réparties sur plusieurs épaisseurs (agrégats à trois dimensions).

Un matériau supraconducteur de type Bi₂Sr₂Caₙ₋₁CuₙO_{y} (n= 2,3,4,5) sous forme de film constitué de couches mono-moléculaires superposées les unes aux autres sur un substrat est connu de l'article de Y. Nakayama et al., J. Appl. Phys. 70(8), 15 Octobre 1991, pages 4371 à 4377.

En outre, dans plusieurs exemples de matériaux supraconducteurs connus, les couches supraconductrices sont constituées d'un oxyde de cuivre planaire, en général CuO₂, souvent appelé cuprate.

Les matériaux supraconducteurs connus ont une température critique qui ne dépasse pas 135 K à pression atmosphérique, et 155 K sous très forte pression.

Autrement dit, les matériaux supraconducteurs connus doivent être refroidis au-dessous de 135 K à pression atmosphérique pour devenir supraconducteurs, ce qui génère des coûts d'exploitation très élevés et de grandes difficultés techniques.

La présente invention a pour but de remédier à cet inconvénient.

A cet effet, selon la présente invention, un matériau supraconducteur du genre en question est essentiellement caractérisé en ce que les couches intercalaires ont la formule chimique Ca₁₋ₓMₓ et sont exemptes de strontium, x étant un nombre réel plus grand que 0 et au plus égal à 0,2, M étant un élément substitué ayant un rayon ionique voisin de celui de l'ion Ca²⁺, les couches intercalaires étant complètes ou comportant des lacunes.

Grâce à ces dispositions, la température critique du matériau supraconducteur est très nettement augmentée et atteint, dans au moins un exemple, 250 K.

Pour atteindre de tels résultats, il est essentiel que le mécanisme de croissance des couches soit strictement monomoléculaire (couche atomique après couche atomique) pour éviter le mélange par diffusion thermique des couches déjà déposées.

Dans des modes de réalisation avantageux, on a recours en outre à l'une et/ou à l'autre des dispositions suivantes :
- l'élément M est Bi ;
- le réservoir de charges électriques est constitué par au moins deux couches composées d'un oxyde de calcium, séparées par au moins une couche composée d'au moins un oxyde métallique ;
- l'oxyde métallique est un oxyde d'un métal choisi dans le groupe comprenant : Bi, Hg, Tl et Cu ;
- l'oxyde métallique est un oxyde de bismuth ;
- l'oxyde métallique est un oxyde de cuivre ;
- n est au moins égal à 6 et avantageusement au moins égal à 8 ;
- plusieurs cellules supraconductrices sont empilées en alternance avec des réservoirs de charges électriques.

La présente invention a aussi pour objet des composants comprenant un matériau tel que défini ci-dessus, notamment des composants utilisant la résistance voisine de zéro du matériau supraconducteur, tels que les interconnexions, les transistors rapides et les composants hyperfréquence, ou encore les composants utilisant des jonctions Josephson, tels que les dispositifs supraconducteurs à interférence quantique ("SQUID"), et les dispositifs de commutation ou de mémoire rapide pour l'électronique digitale.

D'autres caractéristiques et avantages du matériau selon l'invention, ainsi que le procédé d'obtention de ce matériau, apparaîtront au cours de la description suivante d'un mode de réalisation préféré, donné à titre d'exemple non limitatif, en regard des dessins joints.

Sur les dessins :
- la figure 1 est une vue schématique en coupe représentant un matériau supraconducteur selon un mode de réalisation préféré de l'invention,
- la figure 2 est une vue schématique d'un appareillage permettant de fabriquer le matériau selon l'invention, et
- la figure 3 est une vue représentant l'évolution au cours du temps de l'intensité d'une raie de diffraction électronique RHEED pendant le dépôt d'une couche monomoléculaire.

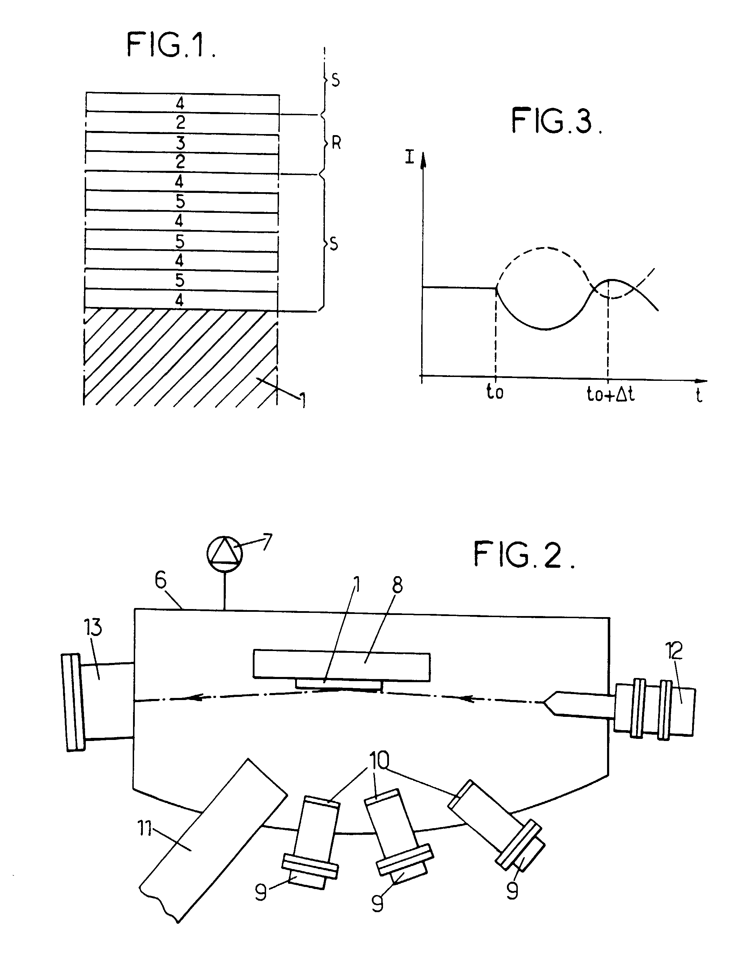

Dans l'exemple de réalisation particulier représenté sur la figure 1, le matériau supraconducteur selon l'invention se présente sous la forme d'un film multicouches déposé sur un substrat 1 parfaitement poli, de préférence un monocristal de titanate de strontium (SrTiO₃) ou d'oxyde de magnésium (MgO), ou autre.

Le film qui est déposé sur le substrat 1 est constitué de couches monomoléculaires superposées les unes aux autres.

Ces couches monomoléculaires sont réparties en deux types d'ensembles : des réservoirs de charges électriques R, qui dans l'exemple représenté sont constitués chacun par trois couches successives 2, 3, 2, et des cellules supraconductrices S, qui sont constituées par un certain nombre de couches supraconductrices 4 séparées deux à deux par des couches intercalaires 5, n étant égal à 4 dans l'exemple représenté.

Le film multicouches déposé sur le substrat 1 comporte de préférence plusieurs cellules supraconductrices S et plusieurs réservoirs de charges R superposés en alternance.

Lorsque le film comporte plusieurs cellules supraconductrices S dans son épaisseur, ce qui est le cas le plus général, le nombre n de couches supraconductrices 4 contenues dans une cellule supraconductrice peut éventuellement être différent d'une cellule supraconductrice S à l'autre. Toutefois, selon l'invention, le film comporte au moins une cellule pour laquelle n est supérieur ou égal à 4, et de préférence n est supérieur ou égal à 4 pour toutes les cellules S.

De façon préférentielle, n est au moins égal à 6.

Selon l'invention, les couches supraconductrices 4 sont constituées d'un oxyde de cuivre de formule chimique CuO₂, et les couches intercalaires 5 sont de formule chimique Ca₁₋ₓMₓ, x étant un nombre réel supérieur à 0 et inférieur ou égal à 0,2.

M est un élément monovalent, divalent ou trivalent ayant un rayon ionique voisin de celui de l'ion Ca²⁺, de préférence le bismuth.

Les couches intercalaires 5 à base de calcium sont exemptes de strontium, au contraire des couches intercalaires à base de calcium dans les matériaux supraconducteurs connus.

Les couches intercalaires 5 peuvent être éventuellement incomplètes, c'est-à-dire comporter des lacunes.

En outre, dans l'exemple considéré, chaque réservoir de charges R est constitué par deux couches 2 constituées d'un oxyde de calcium, séparées par une couche 3 constituée au moins d'un oxyde métallique, le métal de cet oxyde pouvant être en particulier le bismuth, le mercure, le thalium ou le cuivre.

Le nombre de couches 2 de chaque réservoir R pourrait être supérieur à 2, par exemple de l'ordre de 10, les couches 2 d'oxyde de calcium étant alors séparées deux à deux par des couches 3 d'oxyde métallique.

Dans un exemple particulier, qui a fait l'objet d'essais, le nombre n de couches supraconductrices de chaque cellule supraconductrice S était égal à 8, x était non nul mais inférieur à 0,1 et la couche intermédiaire 3 du réservoir de charges R était un oxyde de bismuth.

Dans cet exemple particulier, on a pu mesurer une chute très rapide de la résistance électrique d'un échantillon du matériau réalisé lorsque sa température est abaissée, cette résistance devenant sensiblement nulle à une température de l'ordre de 250 K à pression atmosphérique, soit 115 K de plus que les matériaux supraconducteurs connus dont la température critique est la plus élevée à pression atmosphérique.

Pour réaliser le matériau selon l'invention, on peut avantageusement utiliser la technique dite de l'épitaxie par jet moléculaire (MBE).

Pour cela, comme représenté sur la figure 2, on dispose le substrat 1 sur un support chauffant 8, dans une chambre à vide 6 reliée à une pompe à vide 7 capable de réaliser un vide poussé.

Le support chauffant 8 chauffe le substrat 1 à une température inférieure à 600°C, et préférentiellement à une température comprise entre 300 et 600°C, notamment comprise entre 300 et 550°C et par exemple comprise entre 300 et 500°C.

La chambre à vide 6 comporte plusieurs cellules de Knudsen 9, chaque cellule 9 comportant classiquement une charge d'un élément à faire évaporer, des moyens de chauffage pour faire évaporer cet élément dans la chambre à vide, et une ouverture dirigée vers la chambre à vide, laquelle ouverture peut être obturée par un couvercle 10. Une fois sous forme -de vapeur dans la chambre à vide, l'élément évaporé se condense sur les parois qu'il rencontre, et en particulier sur le substrat 1. Tel qu'employé ici, le terme "évaporer" signifie que des atomes ou des groupes d'atomes de l'élément à déposer quittent la charge contenue dans la cellule de Knudsen sous l'effet d'un apport d'énergie, puis parcourent une certaine distance dans la chambre à vide avant de se déposer sur le substrat 1.

Dans l'exemple représenté, le dispositif comporte trois cellules 9, permettant de faire évaporer respectivement du cuivre, du calcium, et du bismuth ou un autre métal.

Pour chaque cellule 9, la fermeture du couvercle 10 permet d'empêcher la pénétration dans la chambre à vide des vapeurs de l'élément chauffé dans ladite cellule 9. En outre, il est possible de régler la puissance de chauffage de chaque cellule. Ceci permet de régler la vitesse d'évaporation du matériau contenu dans chaque cellule, et donc le flux de ce matériau arrivant sur le substrat 1 ou sur une couche déjà déposée sur le substrat 1.

En outre, la puissance de chauffage de chaque cellule de Knudsen 9 est réglée pour que le flux d'atomes arrivant sur le substrat 1 ou sur une couche déjà déposée sur ce substrat, et provenant des différentes cellules de Knudsen 9 en fonctionnement à un instant donné, soit compris entre 10¹² et 10¹⁵ atomes/cm².s, notamment entre 10¹² et 10¹⁴ atomes/cm².s et de préférence voisin de 10¹³ atomes/cm².s, ce qui correspond sensiblement à la réalisation d'une couche en 100 secondes.

Le flux d'atomes en question doit de façon générale être compris entre une valeur nominale en deçà de laquelle on ne peut pas former de couche monoatomique, et une valeur maximale au-delà de laquelle on forme obligatoirement des agrégats d'atomes à trois dimensions qui empêchent la formation d'une couche strictement monoatomique. Ces valeurs minimale et maximale sont déterminées expérimentalement pour chaque matériau à déposer.

En outre, le dispositif comporte une source d'oxygène atomique 11 qui peut être par exemple la source OPS (Oxygène Plasma Source) commercialisée par la société RIBER (France).

Pour la réalisation des couches comportant de l'oxygène, la source d'oxygène moléculaire 11 crée au voisinage du substrat 1 une pression locale en oxygène atomique comprise entre 10⁻⁶ et 10 Pa, par exemple entre 10⁻⁴ et 10⁻³ Pa.

De plus, dans les exemples de mise en ouvre du procédé de réalisation du matériau selon l'invention, la source d'oxygène atomique utilisée produisait une pression locale en oxygène moléculaire sensiblement égal à 10 fois la pression locale en oxygène atomique.

Enfin, le dispositif comporte un système de diffraction par réflexion d'électrons à haute énergie (RHEED), ce système comportant un canon à électrons 12, capable d'accélérer un faisceau d'électrons sous une énergie qui peut être par exemple de 35 kev, associé à un écran fluorescent 13.

Lors de la réalisation de chaque couche monomoléculaire du film supraconducteur, le ou les couvercles 10 des cellules de Knudsen 9 correspondant aux éléments à déposer dans ladite couche sont ouverts et les autres restent fermés. Les cellules sont chauffées en permanence, seuls les couvercles 10 permettant d'interrompre le dépôt.

Par exemple, pour réaliser une couche supraconductrice 4 de CuO₂, seul le couvercle 10 de la cellule de Knudsen 9 contenant du cuivre est ouvert.

Pour réaliser une couche intercalaire 5, le couvercle 10 de la cellule de Knudsen 9 contenant du calcium est ouvert. Le couvercle 10 de la cellule de Knudsen 9 contenant du bismuth est ouvert lui aussi. Les puissances de chauffage des deux cellules de Knudsen contenant du calcium et du bismuth sont réglées au préalable de façon que le flux total d'atomes de calcium et de bismuth arrivant sur la dernière couche déposée sur le substrat 1 soit compris entre 10¹² et 10¹⁵ et préférentiellement entre 10¹² et 10¹⁴ atomes/cm².s, et pour respecter la proportion voulue entre le bismuth et le calcium.

La source d'oxygène atomique 11 est dans tous les cas en fonctionnement. En outre, pour déposer une couche 2, le couvercle 10 de la cellule de Knudsen 9 contenant du calcium est ouvert. De même, pour réaliser une couche 3, le couvercle 10 de la cellule de Knudsen 9 contenant du bismuth est ouvert.

Au cours du dépôt de chaque couche monomoléculaire, l'écran 13 est surveillé.

Cette surveillance permet tout d'abord de détecter toute formation éventuelle d'agrégats à trois dimensions, qui pourrait avoir lieu malgré les précautions prises. Une telle formation d'agrégats est détectée par l'apparition de points sur l'écran. Dans ce cas, la fabrication du film supraconducteur est arrêtée et le film commencé est mis au rebut.

En outre, l'écran 13 fait normalement apparaître un réseau de lignes lumineuses parallèles que nous appellerons ici "raies de diffraction", et dont l'intensité lumineuse spéculaire I est mesurée au cours du temps, comme représenté sur la figure 3. Ainsi, au début de la réalisation d'une nouvelle couche à partir d'un instant t₀ entraîne une baisse de l'intensité I, qui passe d'abord en général par un minimum, puis qui atteint un maximum à un instant t₀ + Δt (courbe en trait plein). Eventuellement, l'intensité I peut passer d'abord par un maximum, puis par un minimum à t₀ + Δt (courbe en pointillés).

Selon l'invention, les couvercles 10 des cellules de Knudsen en fonctionnement pour la réalisation de cette couche sont fermés à l'instant t₀ + Δt, et la source d'oxygène atomique est également arrêtée à cet instant.

On évite ainsi la formation d'agrégats d'atomes à trois dimensions qui seraient dus à un surplus de matière par rapport à la quantité minimale nécessaire pour obtenir une couche monomoléculaire.

Après réalisation du film supraconducteur complet, celui-ci est sorti de la chambre à vide 6, puis de préférence chauffé pendant quelques minutes, par exemple à 100°C, sous une atmosphère d'oxygène moléculaire ou une autre atmosphère oxydante.

Le procédé d'obtention du matériau supraconducteur selon l'invention n'est pas limité à l'exemple décrit, mais est susceptible de nombreuses variantes, notamment celles dans lesquelles :
- les jets moléculaires sont obtenus non plus par des cellules de Knudsen, mais par chauffage d'un matériau par un canon à électrons, ou par ablation laser,
- le support 8 n'est pas chauffant, et seule la surface du substrat ou de la dernière couche déposée est chauffée, par exemple par un faisceau laser ou autre.

## Revendications

1. Matériau supraconducteur sous forme de film constitué de couches monomoléculaires (2,3,4,5) superposées les unes aux autres sur un substrat (1), comportant au moins un premier ensemble (R) de couches qui constitue un réservoir de charges électriques et au moins un deuxième ensemble (S) de couches qui forme une cellule supraconductrice et qui est constitué par un nombre entier n au moins égal à 4 de couches supraconductrices (4) composées d'oxyde de cuivre de forme CuO₂, séparées les unes des autres par des couches intercalaires (5), le réservoir de charges (R) et la cellule supraconductrice (S) étant contigus dans l'empilage de couches, caractérisé en ce que les couches intercalaires ont la formule chimique Ca₁₋ₓMₓ et sont exemptes de strontium, x étant un nombre réel plus grand que 0 et au plus égal à 0,2, M étant un élément substitué ayant un rayon ionique voisin de celui de l'ion Ca²⁺, les couches intercalaires étant complètes ou comportant des lacunes.

2. Matériau selon la revendication 1, dans lequel l'élément M est Bi.

3. Matériau selon l'une quelconque des revendications 1 et 2, dans lequel le réservoir de charges électriques est constitué par au moins deux couches (2) composées d'un oxyde de calcium, séparées par au moins une couche (3) composée d'au moins un oxyde métallique.

4. Matériau selon la revendication 3, dans lequel l'oxyde métallique est un oxyde d'un métal choisi dans le groupe comprenant : Bi, Hg, Tl, et Cu.

5. Matériau selon la revendication 4, dans lequel l'oxyde métallique est un oxyde de bismuth.

6. Matériau selon la revendication 4, dans lequel l'oxyde métallique est un oxyde de cuivre.

7. Matériau selon l'une quelconque des revendications précédentes, dans lequel n est au moins égal à 6.

8. Matériau selon l'une quelconque des revendications précédentes, dans lequel n est au moins égal à 8.

9. Matériau selon l'une quelconque des revendications précédentes, comportant plusieurs cellules supraconductrices (S) qui sont empilées en alternance avec des réservoirs de charges électriques (R).

10. Composant électronique comprenant un matériau selon l'une quelconque des revendications précédentes, ledit composant étant choisi dans le groupe comprenant les interconnexions, les transistors rapides et les composants hyperfréquence.

11. Composant électronique comprenant un matériau selon l'une quelconque des revendication 1 à 9, ledit composant comportant des jonctions Josephson.

12. Composant électronique selon la revendication 11, choisi dans le groupe comprenant les dispositifs supraconducteurs à interférence quantique, et les dispositifs de commutation ou de mémoire rapide pour l'électronique digitale.

## Patentansprüche

1. Supraleitendes Material in Form eines aus auf einem Substrat (1) übereinandergeschichteten, monomolekularen Schichten (2, 3, 4, 5) bestehenden Films, mit wenigstens einer ersten Gruppe (R) von Schichten, die ein Reservoir elektrischer Ladungen bildet, und mit wenigstens einer zweiten Gruppe (S) von Schichten, die eine supraleitende Zelle bildet und die aus einer ganzen Zahl n wenigstens gleich 4 von supraleitenden Schichten (4) besteht, welche aus Kupferoxid vom Typ CuO₂ bestehen und voneinander durch Zwischenschichten (5) getrennt sind, wobei das Reservoir elektrischer Ladungen (R) und die supraleitende Zelle (S) in der lagenweisen Anordnung der Schichten einander benachbart sind, dadurch gekennzeichnet, daß die Zwischenschichten die chemische Formel Ca₁₋ₓMₓ haben und frei von Strontium sind, wobei x eine reelle Zahl größer 0 und maximal gleich 0,2 ist, wobei M ein substituiertes Element mit einem lonenradius ist, der nahe dem des Ca²⁺-Ions liegt, wobei die Zwischenschichten vollständig sind oder Lücken aufweisen.

2. Material nach Anspruch 1, wobei es sich bei dem Element M um Bi handelt.

3. Material nach einem der Ansprüche 1 und 2, wobei das Reservoir elektrischer Ladungen aus wenigstens zwei aus einem Kalziumoxid bestehenden Schichten (2) gebildet ist, die durch wenigstens eine aus wenigstens einem Metalloxid bestehende Schicht (3) getrennt sind.

4. Material nach Anspruch 3, wobei das Metalloxid ein Oxid eines aus der Bi, Hg, Tl und Cu umfassenden Gruppe ausgewählten Metalls ist.

5. Material nach Anspruch 4, wobei das Metalloxid ein Wismutoxid ist.

6. Material nach Anspruch 4, wobei das Metalloxid ein Kupferoxid ist.

7. Material nach einem der vorhergehenden Ansprüche, wobei n wenigstens gleich 6 ist.

8. Material nach einem der vorhergehenden Ansprüche, wobei n wenigstens gleich 8 ist.

9. Material nach einem der vorhergehenden Anspiüche, das mehrere supraleitende Zellen (S) umfaßt, die im Wechsel mit den Reservoiren elektrischer Ladungen (R) geschichtet sind.

10. Elektronisches Bauteil mit einem Material nach einem der vorhergehenden Ansprüche, wobei das Bauteil aus der die Verbindungssysteme, schnelle Transistoren und Ultrahochfrequenzbauteile umfassenden Gruppe ausgewählt wird.

11. Elektronisches Bauteil mit einem Material nach einem der Ansprüche 1 bis 9, wobei das Bauteil Josephson-Übergänge aufweist.

12. Elektronisches Bauteil nach Anspruch 11, das aus der die Supraleitervorrichtungen mit Quanteninterferenz und die Schalt- oder Speichervorrichtungen mit schnellem Zugriff für die Digitalelektronik umfassenden Gruppe ausgewählt wird.

## Claims

1. Superconducting material in the form of a film consisting of monomolecular layers (2, 3, 4, 5) superposed with one another on a substrate (1), including at least one first assembly (R) of layers which constitutes an electric charge reservoir, and at least one second assembly (S) of layers which forms a superconducting cell and which consists of a certain integer n at least equal to 4 of superconducting layers (4) composed of copper oxide of the form CuO₂, separated from one another by intermediate layers (5), the charge reservoir (R) and the superconducting cell (S) being adjacent in the stack of layers, characterized in that the intermediate layers have the chemical formula Ca₁₋-ₓMₓ and are free of strontium, x being a real number greater than 0 and at most equal to 0.2, M being a substitute element having an ionic radius close to that of the Ca²⁺ ion, and the intermediate layers being complete or containing vacancies.

2. Material according to claim 1, in which the element M is Bi.

3. Material according to either of claims 1 and 2, in which the electric charge reservoir consists of at least two layers (2) composed of a calcium oxide, which are separated by at least one layer (3) composed of at least one metal oxide.

4. Material according to claim 3, in which the metal oxide is an oxide of a metal chosen from the group comprising: Bi, Hg, Tl and Cu.

5. Material according to claim 4, in which the metal oxide is a bismuth oxide.

6. Material according to claim 4, in which the metal oxide is a copper oxide.

7. Material according to any one of the preceding claims, in which n is at least equal to 6.

8. Material according to any one of the preceding claims, in which n is at least equal to 8.

9. Material according to any one of the preceding claims, including a plurality of superconducting cells (S) which are stacked alternately with electric charge reservoirs (R).

10. Electronic component comprising a material according to any one of the preceding claims, said component being chosen from the group comprising interconnections, fast transistors and microwave components.

11. Electronic component comprising a material according to any one of claim [sic] 1 to 9, said component including Josephson junctions.

12. Electronic component according to claim 11, chosen from the group comprising superconducting quantum interference devices and fast memory or switching devices for digital electronics.
